# EUROPÄISCHE PATENTSCHRIFT

(11) **EP 2 264 892 B1**
(45) Veröffentlichungstag und Bekanntmachung des Hinweises auf die Patenterteilung: **03.10.2018**
(21) Anmeldenummer: 10003377.8
(22) Anmeldetag: 29.03.2010
(51) Int. Cl.: H03H 17/02, H04J 1/05

(54) **Verfahren und Vorrichtung zur Signal-Analyse und -Synthese**
Method and device for signal analysis and synthesis
Procédé et dispositif d'analyse et de synthèse du signal

(30) Priorität: 17.06.2009 DE 102009025218
(43) Veröffentlichungstag der Anmeldung: 22.12.2010
(73) Patentinhaber: Rohde & Schwarz GmbH & Co. KG, 81671 München (DE)
(72) Erfinder: Nitsch, Bernhard, 81825 München (DE); Wiemer, Ingo, Dr., 85241 Hebertshausen (DE); Robelly, Pablo, Dr., Quito (EC)
(74) Vertreter: Körfer, Thomas

(56) Entgegenhaltungen:
- US-A1- 2004 042 557
- US-B1- 6 426 983

## Beschreibung

Die Erfindung betrifft ein Verfahren und Vorrichtung zur Signalanalyse und Signalsynthese.

In der Signalanalysetechnik ist es häufig notwendig, breitbandige Signale, welche aus einer Mehrzahl von einzelnen Teilsignalen bestehen, zu untersuchen. Dabei wird herkömmlicherweise mit einem Bandpassfilter ein zu betrachtender Teil des breitbandigen Signals herausgegriffen und dieses Teilsignal einzeln analysiert. Um so jedoch das gesamte breitbandige Signal zu untersuchen, ist ein großer Aufwand notwendig.

Die deutsche Offenlegungsschrift DE 101 13 878 A1 zeigt eine Vorrichtung zur Zerlegung eines Signals. Dabei wird das breitbandige Eingangssignal zunächst abgetastet und in ein digitales Signal gewandelt. Anschließend wird es in einzelne Teilbandsignale aufgeteilt. Ein Teil dieser Teilbandsignale wird anschließend zu einem reduzierten Ausgangssignal zusammengefasst. Der Aufwand, dieses reduzierte Ausgangssignal zu analysieren, ist geringer als der Aufwand zur Analyse des Eingangssignals. Nachteilhaft ist hier jedoch, dass lediglich ein festes Kanalraster verarbeitet werden kann. Die Untersuchung gänzlich unbekannter Signale ist so nicht möglich. Weiterhin ergibt sich auch hier ein hoher Verarbeitungsaufwand, da die Mittel zur Zerlegung und Zusammenfassung der Signale jeweils nur in einem engen Frequenzbereich arbeiten. Es müssen so Mittel für eine Vielzahl von Frequenzbereichen vorgehalten werden.

Das Dokument US 2004/0042557 A1 zeigt ein Filterdesign zur Teilband-Rekonstruktion. Dabei wird ein Eingangssignal in den Frequenzbereich gewandelt. Innerhalb einer Vielzahl von Frequenzkanälen wird jeweils die Leistung des Signals bestimmt. Lediglich Signale aus Kanälen, welche eine Leistung oberhalb eines bestimmten Schwellwerts aufweisen, werden weiter verarbeitet. Teil dieser Weiterverarbeitung ist, das die Signale dieser Kanäle im Frequenzbereich aneinander gefügt und zurück in den Zeitbereich gewandelt werden. Dabei werden eine Vielzahl von paralleler Verarbeitungseinrichtungen für die Teilband-Signale eingesetzt.

Das Dokument US 6,426,983 B1 zeigt ein Filterdesign zur Entfernung von Schmalband-Interferenz. Dabei wird eine Matrix von Polyphasenfiltern eingesetzt. Auch hier werden zahlreiche parallele Verarbeitungseinrichtungen für verschiedene Frequenzbereiche genutzt.

Der Erfindung liegt die Aufgabe zugrunde, ein Verfahren und eine Vorrichtung zu schaffen, welche eine aufwandsarme Untersuchung unbekannter Signale ermöglichen.

Eine erfindungsgemäße Signalverarbeitungseinrichtung beinhaltet eine Signalanalyseeinrichtung, eine Signalsyntheseeinrichtung und eine Detektionseinrichtung. Die Signalanalyseeinrichtung empfängt ein Eingangssignal und erzeugt daraus mehrere Teilbandsignale. Die Signalsyntheseeinrichtung erzeugt aus zumindest einem Teilbandsignal zumindest ein Ausgangssignal. Die Detektionseinrichtung bestimmt automatisch, aus welchen Teilbandsignalen die Signalsyntheseeinrichtung das Ausgangssignal erzeugt. Die Detektionseinrichtung bestimmt bevorzugt die Leistung in mehreren Teilbändern des Eingangssignals. Die Detektionseinrichtung bestimmt bevorzugt automatisch anhand der Leistungen der Teilbandsignale, aus welchen Teilbandsignalen die Signalsyntheseeinrichtung das Ausgangssignal erzeugt. Das Eingangssignal beinhaltet mehrere Teilsignale. Die Signalsyntheseeinrichtung der Signalverarbeitungseinrichtung verarbeitet die mehreren Teilsignale sequentiell. Die von der Signalverarbeitungseinrichtung zur Verarbeitung eines Teilsignals benötigte Verarbeitungszeit ist direkt proportional zu der Bandbreite des jeweiligen Teilsignals. So werden mit geringem Aufwand relevante Signalanteile zusammengefasst.

Die Signalsyntheseeinrichtung erzeugt vorteilhafterweise aus mehreren Teilbandsignalen zumindest ein Ausgangssignal. Die Signalsyntheseeinrichtung verarbeitet vorteilhafterweise die mehreren Teilbandsignale parallel. So ist der Aufbau der Signalsyntheseeinrichtung mit nur sehr geringem Aufwand möglich. Eine konstante maximale Verarbeitungszeit wird so erreicht.

Die Signalsyntheseeinrichtung erzeugt bevorzugt aus mehreren auf der Frequenzachse benachbarten Teilbandsignalen ein gemeinsames Ausgangssignal. So ist die Verarbeitung breitbandiger Eingangssignale, welche in mehrere Teilbandsignale aufgeteilt werden, möglich.

Vorteilhafterweise tastet die Signalanalyseeinrichtung das Eingangssignal mit einer ersten Abtastrate ab, welche zumindest der doppelten in dem Eingangssignal vorkommenden Frequenz entspricht. Bevorzugt erzeugt die Signalsyntheseeinrichtung das zumindest eine Ausgangssignal mit einer zweiten Abtastrate. Bevorzugt bestimmt die Signalsyntheseeinrichtung die zweite Abtastrate derart, dass sämtliche in dem zumindest einen Teilbandsignal, aus welchem sie das Ausgangssignal erzeugt, enthaltenen Informationen in dem Ausgangssignal enthalten sind. Die zweite Abtastrate ist bevorzugt geringer oder gleich der ersten Abtastrate. So wird der Aufwand der weiteren Verarbeitung reduziert.

Die Signalverarbeitungsvorrichtung beinhaltet vorteilhafterweise eine Verarbeitungseinrichtung. Die Verarbeitungseinrichtung analysiert bevorzugt das zumindest eine Ausgangssignal. So ist eine aufwandsarme zuverlässige Weiterverarbeitung gewährleistet.

Die Signalverarbeitungsvorrichtung beinhaltet bevorzugt eine Speichereinrichtung. Zumindest ein Teilbandsignal wird bevorzugt von der Speichereinrichtung gespeichert. So können die Teilbandsignale trotz Zeitverzögerung durch die Detektion in Echtzeit verarbeitet werden.

Bevorzugt beinhaltet die Signalanalyseeinrichtung eine erste Polyphasenfilterbank. Bevorzugt beinhaltet die Signalsyntheseeinrichtung eine zweite Polyphasenfilterbank. So ist eine einfache, aufwandsarme Transformation gewährleistet.

Zumindest die Signalanalyseeinrichtung, die Detektionseinrichtung und die Signalsyntheseeinrichtung sind bevorzugt durch zumindest ein feldprogrammierbares Gatter Array (FPGA) oder eine applikationsspezifische integrierte Schaltung (ASIC) realisiert. So kann der Aufwand der Herstellung und Entwicklung der Vorrichtung weiter reduziert werden.

Nachfolgend wird die Erfindung anhand der Zeichnung, in der ein vorteilhaftes Ausführungsbeispiel der Erfindung dargestellt ist, beispielhaft beschrieben. In der Zeichnung zeigen:
- Fig. 1: ein erstes beispielhaftes Signal zur Erläuterung der Erfindung;
- Fig. 2a: ein zweites beispielhaftes Signal zur Erläuterung der Erfindung;
- Fig. 2b: ein drittes beispielhaftes Signal zur Erläuterung der Erfindung;
- Fig. 3: ein viertes beispielhaftes Signal zur Erläuterung der Erfindung;
- Fig. 4: ein fünftes beispielhaftes Signal zur Erläuterung der Erfindung;
- Fig. 5: ein erstes Ausführungsbeispiel der erfindungsgemäßen Vorrichtung;
- Fig. 6: ein zweites Ausführungsbeispiel der erfindungsgemäßen Vorrichtung;
- Fig. 7: ein drittes Ausführungsbeispiel der erfindungsgemäßen Vorrichtung;
- Fig. 8: in einem Diagramm die Bandbreite und den Verarbeitungszeitbedarf mehrerer beispielhafter Signale bei Verarbeitung mit einer erfindungsgemäßen Vorrichtung, und
- Fig. 9: ein Blockdiagramm eines Ausführungsbeispiels des erfindungsgemäßen Verfahrens.

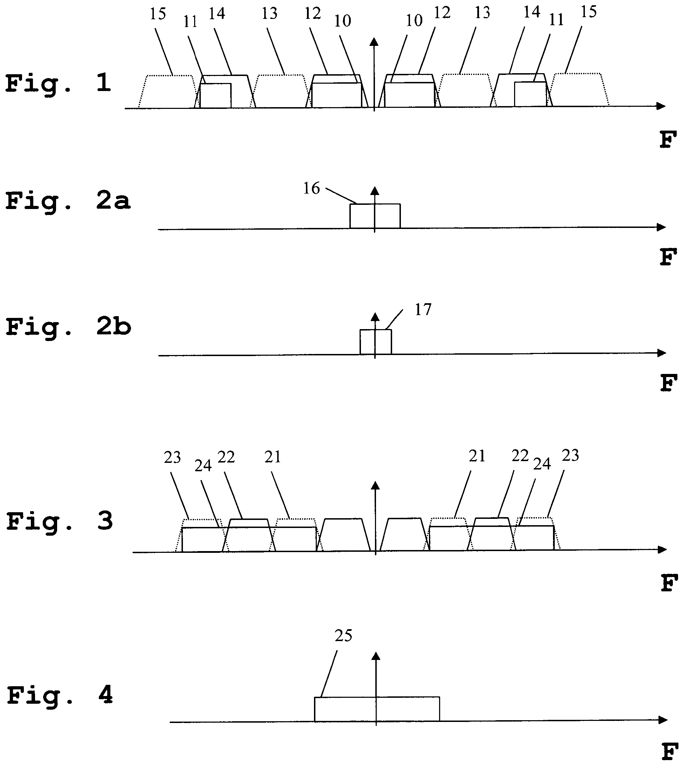

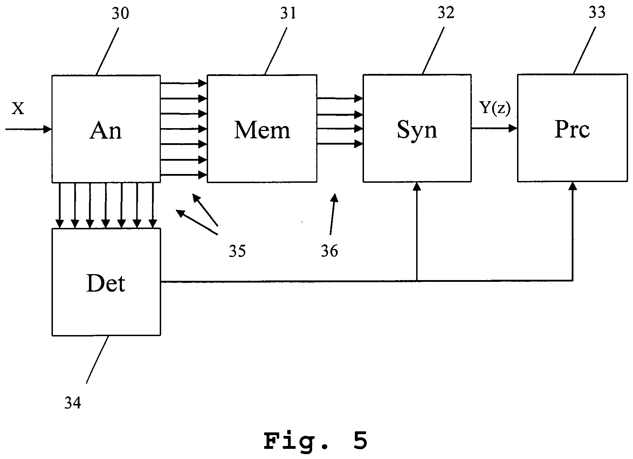

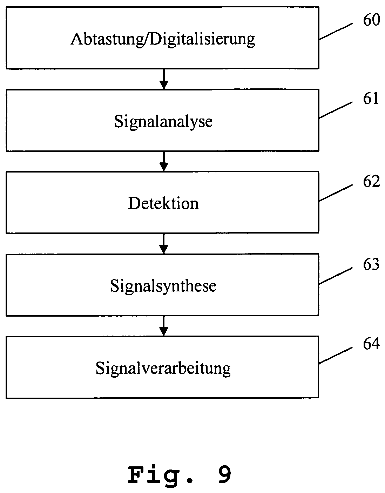

Zunächst wird anhand der Fig. 1 - 4 die zugrundeliegende Problematik und das der Erfindung zugrunde liegende Konzept erläutert. Mittels Fig. 5 - 8 wird anschließend der Aufbau und die Funktionsweise verschiedener Ausführungsbeispiele der erfindungsgemäßen Vorrichtung veranschaulicht. Anhand der Fig. 9 wird abschließend die Funktionsweise eines Ausführungsbeispiels des erfindungsgemäßen Verfahrens gezeigt. Identische Elemente werden in ähnlichen Abbildungen zum Teil nicht wiederholt dargestellt und beschrieben.

Fig. 1 zeigt ein erstes beispielhaftes Signal. Das Breitbandsignal ist aus zwei Teilsignalen 10, 11 zusammengesetzt. Das beispielhafte Signal wird im Frequenzbereich dargestellt. D.h. das Signal besteht aus einem niederfrequenten Teilsignal 10 und einem hochfrequenten Teilsignal 11. Erfindungsgemäß wird das breitbandige Signal in eine Mehrzahl von Teilbandsignalen aufgespalten. Dargestellt sind hier die dazu eingesetzten Filter 12, 13, 14 und 15. Die Teilsignale 10, 11 werden jeweils von einem Filter 12, 14 erfasst. Zur Reduktion der Bandbreite des breitbandigen Signals und zur Reduktion des Arbeitsaufwands werden lediglich Teilbandsignale, welche eine Leistung über einer bestimmten Schwelle aufweisen, weiterverarbeitet. Im Beispiel weisen lediglich die von den Filtern 12, 14 abgedeckten Teilbandsignale eine ausreichend hohe Leistung auf.

Fig. 2a und Fig. 2b zeigen aus den von den Filtern 12, 14 bestimmten Teilbandsignalen aus Fig. 1 erzeugte Ausgangssignale. Das jeweilige Ausgangssignal wird ebenfalls im Frequenzbereich dargestellt. In Fig. 2a ist das Teilsignal 16 dargestellt, welches dem Teilsignal 10 aus Fig. 1 entspricht. In Fig. 2b ist das Teilsignal 17 dargestellt, welches dem Teilsignal 11 aus Fig. 1 entspricht. Deutlich erkennbar ist, dass die maximale Frequenz der hier dargestellten Signale 16, 17 deutlich geringer als die maximale Frequenz des Gesamtsignals aus Fig. 1 ist. Eine Reduktion der Abtastrate und damit des weiteren Verarbeitungsaufwands ist so möglich. Gegenüber dem Signal aus Fig. 1 wurden jeweils Teilbandsignale, welche eine lediglich sehr geringe Leistung übertragen, entfernt. Die resultierenden Bandbreiten der Signale entsprechen so lediglich den individuellen Bandbreiten der Teilsignale 10 und 11 aus Fig. 1.

In Fig. 3 wird ein viertes beispielhaftes Signal dargestellt. Das breitbandige Signal beinhaltet hier lediglich ein Teilsignal 24. Das Teilsignal 24 wird dabei von mehreren Filtern 21, 22, 23 erfasst. Es wird detektiert, dass es sich bei den von den Filtern 21, 22, 23 jeweils erfassten Signalanteilen um ein gemeinsames Teilsignal 24 handelt. Wie bereits anhand der Fig. 1, Fig. 2a und Fig. 2b dargestellt, wird auch hier die Bandbreite des Gesamtsignals reduziert.

Das in Fig. 4 dargestellte beispielhafte Signal beinhaltet ein Teilsignal 25. Es entspricht dem Teilsignal 24 aus Fig. 3. Deutlich erkennbar ist hier, dass die höchste Frequenz des Gesamtsignals gegenüber der Fig. 3 deutlich gesunken ist. Eine Absenkung der Abtastrate ist auch hier möglich.

Der Einsatz unterschiedlicher Filterbreiten ist dabei möglich. D.h. je nach gegenwärtig zu analysierendem Signal können schmalbandigere oder breitbandigere Filter eingesetzt werden.

In Fig. 5 wird ein erstes Ausführungsbeispiel der erfindungsgemäßen Vorrichtung dargestellt. Eine Signalanalyseeinrichtung 30 ist mit einem Speicher 31 verbunden. Weiterhin ist sie mit einer Detektionseinrichtung 34 verbunden. Der Speicher 31 ist weiterhin mit einer Signalsyntheseeinrichtung 32 verbunden. Die Signalsyntheseeinrichtung 32 ist weiterhin mit einer Verarbeitungseinrichtung 33 verbunden. Die Detektionseinrichtung 34 ist weiterhin mit der Signalsyntheseeinrichtung 32 und der Verarbeitungseinrichtung 33 verbunden.

Ein breitbandiges Signal X wird der Signalanalyseeinrichtung 30 zugeführt. Es wird von dieser abgetastet und digitalisiert. Weiterhin wird das Eingangssignal X in eine Vielzahl von Teilbandsignalen 35 aufgeteilt. Die Teilbandsignale 35 werden dem Speicher 31 und der Detektionseinrichtung 34 zugeführt. Der Speicher 31 speichert die Teilbandsignale 35. Die Detektionseinrichtung 34 bestimmt, welche Teilbandsignale 36 weiterverarbeitet werden sollen. Hierzu beurteilt sie die Teilbandsignale 35 anhand bestimmter Kriterien. So nutzt sie beispielsweise die Leistung der einzelnen Teilbandsignale 35 als Kriterium. Teilbandsignale 36 mit einer Leistung oberhalb einer bestimmten Schwelle werden weiterverarbeitet, während Teilbandsignale mit einer Leistung unterhalb der Schwelle nicht weiterverarbeitet werden. Die Detektionseinrichtung 34 leitet Informationen die Teilbandsignale 35 und ihre Weiterverarbeitung betreffend an die Signalsyntheseeinrichtung 32 und die Verarbeitungseinrichtung 33 weiter. Entsprechend der Anweisung der Detektionseinrichtung 34 verarbeitet die Signalsyntheseeinrichtung 32 die Teilbandsignale 36 weiter. Hierzu liest die Signalsyntheseeinrichtung 32 lediglich die weiterzuverarbeitenden Teilbandsignale 36 aus dem Speicher 31 aus. Die weiterzuverarbeitenden Teilbandsignale 36 werden von der Signalsyntheseeinrichtung zu einem gemeinsamen Ausgangssignal Y(z) kombiniert. Dieses Ausgangssignal Y(z) wird an die Verarbeitungseinrichtung 33 weitergeleitet. Die Verarbeitungseinrichtung 33 führt weitere Analysen an dem digitalen Ausgangssignal Y(z) durch. So bestimmt sie beispielsweise die genaue Frequenzverteilung des Signals.

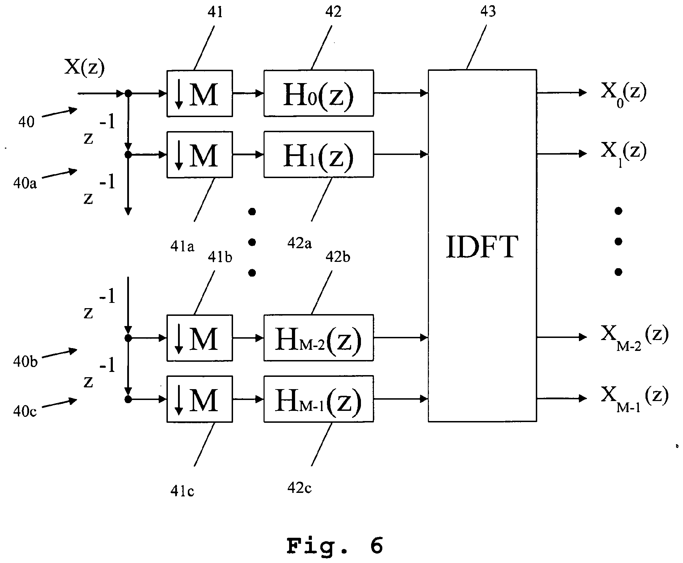

Fig. 6 zeigt ein zweites Ausführungsbeispiel der erfindungsgemäßen Vorrichtung. Hier wird ein Teil der Signalanalyseeinrichtung 30 aus Fig. 5 gezeigt. Das Eingangssignal X aus Fig. 5 liegt hier bereits in abgetasteter und digitalisierter Form X(z) vor. Die Vorrichtung beinhaltet mehrere Verarbeitungszweige 40, 40a, 40b, 40c. Jeder Verarbeitungszweig 40, 40a, 40b, 40c beinhaltet einen Dezimierer 41, 41a, 41b, 41c und einen Filter 42, 42a, 42b, 42c. Weiterhin beinhaltet sie eine Transformationseinrichtung 43. Den Verarbeitungszweigen 40, 40a, 40b, 40c wird jeweils das digitalisierte Eingangssignal zugeführt. Dabei wird dem ersten Verarbeitungszweig 40 das unmodifizierte digitalisierte Eingangssignal zugeführt. Den weiteren Verarbeitungszweigen 40a, 40b, 40c werden jeweils zeitverzögerte digitalisierte Eingangssignale zur Verfügung gestellt. So wird der zweite Verarbeitungszweig 40a mit dem um einen Abtastwert verzögerten digitalisierten Eingangssignal beaufschlagt. So wird jeder weitere Verarbeitungszweig mit einer jeweils um einen Abtastwert ansteigenden Zeitverzögerung im Eingangssignal beaufschlagt.

Die Ausgangssignale der Filter 42, 42a, 42b, 42c werden der Transformationseinrichtung 43 zugeführt. Die Transformationseinrichtung 43 führt eine Transformation der eingegebenen Signale durch. Beispielsweise wird eine inverse diskrete Fourier-Transformation durchgeführt. Hierzu ist eine Vielzahl von Berechnungen notwendig. Diese werden für die einzelnen Teilbandsignale parallel durchgeführt. Die Transformationseinrichtung 43 gibt als Ausgangssignal mehrere Teilbandsignale X₀(z), X₁(z), ..., X_{M-2}(z), X_{M-1}(z) aus. Diese Signale entsprechen jeweils einem Frequenzband des Eingangssignals X(z). Wie anhand von Fig. 5 dargestellt, werden diese Signale der Detektionseinrichtung 34 zugeführt. Die Verarbeitungszweige 40, 40a, 40b, 40c und die Transformationseinrichtung 43 bilden dabei zusammen eine Polyphasenfilterbank.

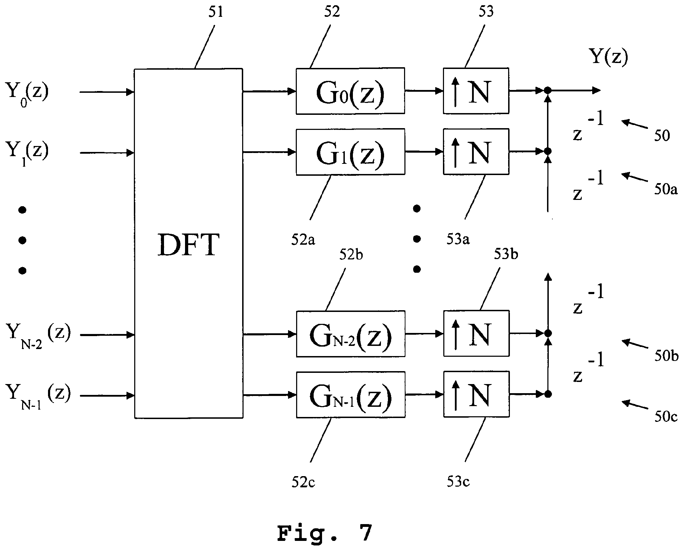

Fig. 7 zeigt ein drittes Ausführungsbeispiel der erfindungsgemäßen Vorrichtung. Hier dargestellt wird ein Teil der Signalsyntheseeinrichtung 32 aus Fig. 5. Die Vorrichtung verfügt über eine Transformationseinrichtung 51 und mehrere Verarbeitungszweige 50, 50a, 50b, 50c. Jeder Verarbeitungszweig 50, 50a, 50b, 50c verfügt über einen Filter 52, 52a, 52b, 52c und eine Abtastratenerhöhungseinrichtung 53, 53a, 53b, 53c. Von der Detektionseinrichtung 34 aus Fig. 5 wurde zumindest ein Teilbandsignal Y₀(z), Y₁(z), ..., Y_{N-2}(z), Y_{N-1}(z) aus den Teilbandsignalen X₀(z), X₁(z), ..., X_{M-2}(z), X_{M-1}(z) aus Fig. 6 ausgewählt. Sie werden der Transformationseinrichtung 51 zugeführt. Die Transformationseinrichtung 51 führt eine Transformation, beispielsweise eine diskrete Fourier-Transformation durch und leitet resultierende Signale weiter an die Verarbeitungszweige 50, 50a, 50b, 50c. Die Verarbeitungszweige 50, 50a, 50b, 50c und die Transformationseinrichtung 51 bilden dabei zusammen eine Polyphasenfilterbank. Die Transformationseinrichtung 51 verarbeitet dabei die jeweils ausgewählten Teilbandsignale parallel. Sollen mehrere unterschiedliche Teilsignale 10, 11 aus Fig. 1 verarbeitet werden, werden diese nacheinander verarbeitet. Überlappen die Teilsignale nicht, so verbleibt die Verarbeitungszeit unabhängig von der jeweiligen Anzahl ausgewählter Teilbandsignale so stets unterhalb einer maximalen Verarbeitungszeit Tₘₐₓ.

Jedes Ausgangssignal der Transformationseinrichtung 51 wird dabei zunächst von einem Filter 52, 52a, 52b, 52c verarbeitet. Anschließend wird jedes gefilterte Signal jeweils einer Abtastratenerhöhungseinrichtung 53, 53a, 53b, 53c zugeführt. Diese erhöht die Abtastrate des jeweiligen Signals. Dies geschieht z.B. durch Zero-Stuffing. D.h. zwischen bereits vorhandene Abtastwerte werden zusätzliche Abtastwerte mit dem Wert 0 eingefügt. Die Signale der einzelnen Verarbeitungszweige 50, 50a, 50b, 50c werden anschließend zu einem gemeinsamen Ausgangssignal Y(z) zusammengefasst. Dies geschieht dergestalt, dass das Signal des ersten Verarbeitungszweigs 50 direkt dem Ausgangssignal Y(z) zugeführt wird. Die Signale der weiteren Verarbeitungszweige 50a, 50b, 50c sind gegenüber dem Signal des vorherigen Verarbeitungszweigs verzögert. Die Verzögerung steigt dabei mit der Signalnummer an. D.h. der zweite Verarbeitungszweig 50a ist um einen Abtastwert verzögert gegenüber dem ersten Verarbeitungszweig 50. Ein hier nicht dargestellter dritter Verarbeitungszweig wäre um zwei Abtastwerte verzögert.

Das resultierende Ausgangssignal Y(z) entspricht einer Kombination der von der Detektionseinrichtung 34 aus Fig. 5 ausgewählten Teilbandsignale in einem gemeinsamen Signal. Dabei sind die Teilbandsignale in ihrer spektralen Position z.T. verschoben. Das Ausgangssignal Y(z) verfügt über eine Bandbreite von höchstens der Bandbreite des Eingangssignals X(z) aus Fig. 6. Dieser Fall tritt lediglich ein, wenn sämtliche Teilbandsignale X₀(z), X_{d}(z), ..., X_{M-2}(z), X_{M-1}(z) von der Detektionseinrichtung 34 aus Fig. 5 ausgewählt wurden. Wurde eine geringere Anzahl von Teilbandsignalen, z.B. X₁(z) und X₂(z) ausgewählt, so ergibt sich eine geringere Bandbreite des Ausgangssignals Y(z). Auf Möglichkeiten der Auswahl von Teilbandsignalen wird anhand von Fig. 9 näher eingegangen.

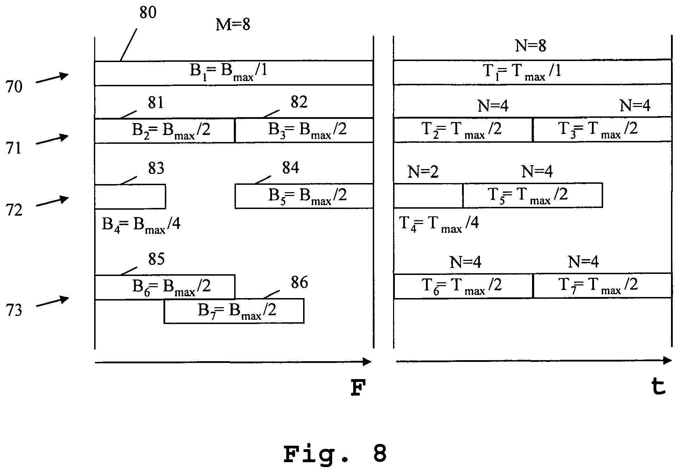

Fig. 8 zeigt die Bandbreite und den Verarbeitungszeitbedarf mehrerer beispielhafter Signale in einem Ausführungsbeispiel der erfindungsgemäßen Vorrichtung. Auf der linken Seite des Diagramms ist der Bandbreitenbedarf mehrerer untereinander angeordneter Beispielfälle gezeigt. Auf der rechten Seite des Diagramms ist die Verarbeitungszeit zur Verarbeitung der einzelnen Signale gezeigt. In diesem Ausführungsbeispiel wird das breitbandige Eingangssignal stets in M = 8 Teilbandsignale identischer Bandbreite zerlegt. Eine Zerlegung in Teilbandsignale unterschiedlicher Bandbreite ist ebenfalls denkbar. Im ersten Beispiel 70 besteht das breitbandige Eingangssignal aus einem einzelnen Teilsignal 80. Das Teilsignal 80 verfügt über die Bandbreite B₁ = Bₘₐₓ / 1. Zur Verarbeitung dieses Teilsignals 80 ist die Zeit T₁ = Tₘₐₓ / 1. D.h. es werden sämtliche N = 8 Teilbandsignale zu einem gemeinsamen Ausgangssignal zusammengefasst.

Im zweiten Beispiel 71 besteht das breitbandige Eingangssignal aus zwei Teilsignalen 81, 82. Beide Teilsignale nehmen jeweils die Hälfte der Bandbreite ein. Das erste Teilsignal 81 verfügt über die Bandbreite B₂ = Bₘₐₓ / 2. Die Bandbreite des zweiten Teilsignals 82 beträgt B₃ = Bₘₐₓ / 2. Zur Verarbeitung dieser beiden Teilsignale 81, 82 wird die Zeit T= T₁ + T₂ = Tₘₐₓ /2 + Tₘₐₓ / 2 benötigt. Dabei werden jeweils N = 4 Teilbandsignale zusammengefasst. Es werden somit nacheinander zwei Ausgangssignale erzeugt. Das erste Ausgangssignal beinhaltet das Teilsignale 81, das zweite Ausgangssignal beinhaltet das Ausgangssignal 82.

Im dritten Beispiel 72 beinhaltet das breitbandige Eingangssignal ein erstes Teilsignal 83 von geringer Frequenz und ein zweites Teilsignal 84 höherer Frequenz. Das erste Teilsignal 83 umfasst dabei lediglich eine geringe Bandbreite B₄ = Bₘₐₓ / 4, während das zweite Teilsignal 84 über eine größere Bandbreite B₅ = Bₘₐₓ / 2 verfügt. Zur Verarbeitung der Teilsignale 83, 84 wird die Zeit T = T₄ + T₅ = Tₘₐₓ / 4 + Tₘₐₓ / 2 benötigt. Es werden erneut nacheinander zwei Ausgangssignale erzeugt. Ein erstes Ausgangssignal beinhaltet das Teilsignal. 83. Ein zweites Ausgangssignal beinhaltet das Teilsignal 84.

Im Beispiel 73 beinhaltet das breitbandige Eingangssignal zwei spektral überlappende Teilsignale 85, 86. Das Teilsignal 85 weist die Bandbreite B₆ = Bₘₐₓ / 2 auf. Das Teilsignal 86 weist die Bandbreite B₇ = Bₘₐₓ / 2 auf. Zur Verarbeitung werden die entsprechenden Teilbandsignale herausgegriffen und erneut kombiniert. D.h. die zur Abbildung des Teilsignals 85 benötigten Teilbandsignale werden zunächst verarbeitet. Die Anzahl der hierfür notwendigen Teilbandsignale beträgt N = 4. Zur Verarbeitung des Teilsignals 85 wird die Zeit T₆ = Tₘₐₓ / 2 benötigt. Anschließend werden die Teilbandsignale zur Verarbeitung des Teilsignals 86 verarbeitet. Überlappende Teilbandsignale werden dabei erneut verarbeitet. Es werden erneut zwei Ausgangssignale nacheinander erzeugt. Ein erstes Ausgangssignal beinhaltet das Teilsignal 85. Ein zweites Ausgangssignal beinhaltet das Teilsignal 86. Hierbei ist ein Rückgriff auf bereits durchgeführte Berechnungen aus der Verarbeitung des Teilsignals 85 bei überlappenden Teilbandsignalen möglich.

Es wird deutlich, dass unabhängig von der Anzahl der Teilsignale innerhalb des breitbandigen Eingangssignals die Verarbeitungszeit stets ein Maximum Tₘₐₓ aufweist. Lediglich bei überlappenden Teilsignalen kann sich eine höhere Verarbeitungszeit ergeben. Es wird so eine sehr große Flexibilität der Verarbeitung beliebiger Anzahlen unterschiedlicher Teilsignale erreicht.

In Fig. 9 wird ein Ausführungsbeispiel des erfindungsgemäßen Verfahrens in einem Blockdiagramm gezeigt. In einem ersten Schritt 60 wird eine Abtastung und Digitalisierung eines breitbandigen Eingangssignals durchgeführt. In einem zweiten Schritt 61 wird das digitalisierte Breitbandsignal in mehrere Teilbandsignale aufgespalten. Die Teilbandsignale sind dabei in einem regelmäßigen Frequenzraster angeordnet. D.h. sie weisen eine einheitliche Bandbreite auf. In einem alternativen Ausführungsbeispiel weisen die Teilbandsignale unterschiedliche Bandbreiten auf.

In einem dritten Schritt 62 werden die mehreren Teilbandsignale anhand bestimmter Kriterien, z.B. ihrer Leistung, selektiert. Es wird zumindest ein Teilbandsignal ausgewählt, welches in einem vierten Schritt 63 zu einem Ausgangssignal umgeformt wird. Wurde lediglich ein einzelnes Teilbandsignal ausgewählt, so wird dieses in einen geeigneten Frequenzbereich transformiert. Die Gesamtbandbreite des Ausgangssignals wird dabei geringer als die Gesamtbandbreite des Eingangssignals, sofern nicht sämtliche Teilbandsignale weiterverarbeitet werden. Wurden im dritten Schritt 62 Signale detektiert, welche sich über mehrere Teilbandsignale erstrecken, so werden die benachbarten Teilbandsignale im vierten Schritt 63 weiterhin in derselben Anordnung in das Ausgangssignal übernommen.

Durch die Reduktion der Bandbreite des Ausgangssignals gegenüber dem breitbandigen Eingangssignal ist weiterhin eine geringere Abtastrate notwendig. Als Teil des vierten Schritts 63 wird die Abtastrate auf die benötigte Abtastrate, d.h. zumindest die doppelte vorkommende Frequenz, reduziert. Durch Verwendung einer höheren Abtastrate, z.B. die vierfache vorkommende Frequenz, wird eine einfache Weiterverarbeitung gewährleistet. In einem fünften Schritt 64 wird das resultierende Signal weiterverarbeitet. Dabei werden z.B. die Spektren der einzelnen im dritten Schritt 62 detektierten Signale bestimmt.

Wurden im dritten Schritt 62 mehrere unabhängige Teilsignale selektiert, so werden der vierte Schritt 63 und der fünfte Schritt 64 für diese nacheinander wiederholt.

Die Erfindung ist nicht auf die dargestellten Ausführungsbeispiele beschränkt. So können beliebige Anzahlen von Teilbandsignalen verarbeitet werden. Auch die Erzeugung mehrerer unterschiedlicher Ausgangssignale ist möglich. Die Anwendung abweichender Kriterien zur Detektion der weiterzuverarbeitenden Teilbandsignale ist ebenfalls möglich. Alle vorstehend beschriebenen Merkmale oder in den Figuren gezeigten Merkmale sind im Rahmen der Erfindung beliebig vorteilhaft miteinander kombinierbar.

## Patentansprüche

1. Signalverarbeitungseinrichtung mit einer Signalanalyseeinrichtung (30), einer Signalsyntheseeinrichtung (32) und einer Detektionseinrichtung (34),
wobei die Signalanalyseeinrichtung (30) ein Eingangssignal (X) empfängt und daraus mehrere Teilbandsignale (35, X₀(z), X₁(z), ..., X_{M-2}(z), X_{M-1}(z)) erzeugt,
wobei die Signalsyntheseeinrichtung (32) aus zumindest einem Teilbandsignal (36, Y₀(z), Y₁(z), ..., Y_{N-2}(z), Y_{N-1}(z)) zumindest ein Ausgangssignal (Y(z)) erzeugt,
wobei die Detektionseinrichtung (34) automatisch bestimmt, aus welchen Teilbandsignalen (36, Y₀(z), Y₁(z), ..., Y_{N-2}(z), Y_{N-1}(z)) die Signalsyntheseeinrichtung (32) das Ausgangssignal (Y(z)) erzeugt,
wobei die Detektionseinrichtung (34) die Leistung der Teilbandsignale (35, (X₀(z), X₁(z), ..., X_{M-2}(z), X_{M-1}(z)) bestimmt,
wobei die Detektionseinrichtung (34) automatisch anhand der Leistungen der Teilbandsignale (35, X₀(z), X₁(z), ..., X_{M-2}(z), X_{M-1}(z)) bestimmt, aus welchen Teilbandsignalen (36, Y₀(z), Y₁(z), ..., Y_{N-2}(z), Y_{N-1}(z)) die Signalsyntheseeinrichtung (32) das Ausgangssignal (Y(z)) erzeugt,
wobei das Eingangssignal (X) mehrere Teilsignale (10, 11, 81, 82, 83, 84, 85, 86) beinhaltet, und
wobei die Signalsyntheseeinrichtung (32) der Signalverarbeitungseinrichtung die mehreren Teilsignale (10, 11, 81, 82, 83, 84, 85, 86) sequentiell verarbeitet, so dass die von der Signalverarbeitungseinrichtung zur Verarbeitung eines Teilsignals (10, 11, 81, 82, 83, 84, 85, 86) benötigte Verarbeitungszeit (T₂, T₃, T₄, T₅, T₆, T₇) direkt proportional zu der Bandbreite des jeweiligen Teilsignals (10, 11, 81, 82, 83, 84, 85, 86) ist.

2. Signalverarbeitungseinrichtung nach Anspruch 1, **dadurch gekennzeichnet,**
**dass** die Signalsyntheseeinrichtung (32) aus mehreren Teilbandsignalen (36, Y₀(z), Y₁(z), ..., Y_{N-2}(z), Y_{N-1}(z)) zumindest ein Ausgangssignal (Y(z)) erzeugt, und
**dass** die Signalsyntheseeinrichtung (32) die mehreren Teilbandsignale (36, Y₀(z), Y₁(z), ..., Y_{N-2}(z), Y_{N-1}(z)) parallel verarbeitet.

3. Signalverarbeitungseinrichtung nach Anspruch 1 oder 2, **dadurch gekennzeichnet,**
**dass** die Signalsyntheseeinrichtung (32) aus mehreren auf der Frequenzachse benachbarten Teilbandsignalen (36,
Y₀(z), Y₁(z), ..., Y_{N-2}(z), Y_{N-1}(z)) ein gemeinsames Ausgangssignal (Y(z)) erzeugt.

4. Signalverarbeitungseinrichtung nach einem der Ansprüche 1 bis 3,
**dadurch gekennzeichnet,**
**dass** die Signalanalyseeinrichtung (30) das Eingangssignal (X) mit einer ersten Abtastrate abtastet, welche zumindest der doppelten in dem Eingangssignal (X) vorkommenden höchsten Frequenz entspricht,
**dass** die Signalsyntheseeinrichtung (32) das zumindest eine Ausgangssignal (Y(z)) mit einer zweiten Abtastrate erzeugt,
**dass** die Signalsyntheseeinrichtung (32) die zweite Abtastrate derart bestimmt, dass sämtliche in dem zumindest einen Teilbandsignal (36, Y₀(z), Y₁(z), ..., Y_{N-2}(z), Y_{N-1}(z)), aus welchem sie das Ausgangssignal (Y(z)) erzeugt, enthaltenen Informationen in dem Ausgangssignal (Y(z)) enthalten sind, und
**dass** die zweite Abtastrate geringer oder gleich der ersten Abtastrate ist.

5. Signalverarbeitungseinrichtung nach einem der Ansprüche 1 bis 4,
**dadurch gekennzeichnet,**
**dass** die Signalverarbeitungseinrichtung eine Verarbeitungseinrichtung (33) beinhaltet, und
**dass** die Verarbeitungseinrichtung (33) das zumindest eine Ausgangssignal (Y(z)) analysiert.

6. Signalverarbeitungseinrichtung nach einem der Ansprüche 1 bis 5,
**dadurch gekennzeichnet,**
**dass** die Signalverarbeitungseinrichtung eine Speichereinrichtung (31) beinhaltet, und
**dass** zumindest ein Teilbandsignal (35, X₀(z), X₁(z) ,..., X_{M-2}(z), X_{M-1}(z)) von der Speichereinrichtung gespeichert wird.

7. Signalverarbeitungseinrichtung nach einem der Ansprüche 1 bis 6,
**dadurch gekennzeichnet,**
**dass** die Signalanalyseeinrichtung (30) eine erste Polyphasenfilterbank beinhaltet, und
**dass** die Signalsyntheseeinrichtung (32) eine zweite Polyphasenfilterbank beinhaltet.

8. Signalverarbeitungseinrichtung nach einem der Ansprüche 1 bis 7,
**dadurch gekennzeichnet,**
**dass** zumindest die Signalanalyseeinrichtung (30), die Detektionseinrichtung (34) und/oder die Signalsyntheseeinrichtung (32) durch zumindest ein feldprogrammierbares Gatter Array (FPGA) oder eine applikationsspezifische integrierte Schaltung (ASIC) realisiert sind.

9. Verfahren zur Signalverarbeitung mit den folgenden Schritten:
- Empfangen eines Eingangssignals (X),
- Erzeugen mehrerer Teilbandsignale (35, X₀(z), X₁(z),..., X_{M-2}(z), X_{M-1}(z)) aus dem Eingangssignal (X),
- Erzeugung zumindest eines Ausgangssignals (Y(z)) aus den Teilbandsignalen (36, Y₀(z), Y₁(z), ..., Y_{N-2}(z), Y_{N-1}(z)),
dass automatisch bestimmt wird, aus welchen Teilbandsignalen (36, Y₀(z), Y₁(z), ..., Y_{N-2}(z), Y_{N-1}(z)) das Ausgangssignal (Y(z)) erzeugt wird,
wobei die Leistung mehrerer Teilbandsignale (35, X₀(z), X₁(z), ..., X_{M-2}(z), X_{M-1}(z)) des Eingangssignals (X) bestimmt wird,
wobei automatisch anhand der Leistungen der Teilbandsignale (35, X₀(z), X₁(z), ..., X_{M-2}(z), X_{M-1}(z)) bestimmt wird, aus welchen Teilbandsignalen (36, Y₀(z), Y₁(z), ..., Y_{N-2}(z), Y_{N-1}(z)) das Ausgangssignal (Y(z)) erzeugt wird,
wobei das Eingangssignal (X) mehrere Teilsignale (10, 11, 81, 82, 83, 84, 85, 86) beinhaltet, und
wobei die mehreren Teilsignale (10, 11, 81, 82, 83, 84, 85, 86) sequentiell verarbeitet werden, so dass die zur Verarbeitung eines Teilsignals (10, 11, 81, 82, 83, 84, 85, 86) benötigte Verarbeitungszeit (T₂, T₃, T₄, T₅, T₆, T₇) direkt proportional zu der Bandbreite des jeweiligen Teilsignals (10, 11, 81, 82, 83, 84, 85, 86) ist.

10. Verfahren nach Anspruch 9,
**dadurch gekennzeichnet,**
**dass** aus mehreren Teilbandsignalen (36, Y₀(z), Y₁(z), ..., Y_{N-2} (z), Y_{N-1}(z)) zumindest ein Ausgangssignal (Y(z)) erzeugt wird, und
**dass** die mehreren Teilbandsignale (36, Y₀(z), Y₁(z), ..., Y_{N-2}(z), Y_{N-1}(z)) parallel verarbeitet werden.

11. Verfahren nach Anspruch 9 oder 10,
**dadurch gekennzeichnet,**
**dass** aus mehreren auf der Frequenzachse benachbarten Teilbandsignalen (36, Y₀(z), Y₁(z), ..., Y_{N-2}(z), Y_{N-1}(z)) ein gemeinsames Ausgangssignal (Y(z)) erzeugt wird.

12. Verfahren nach einem der Ansprüche 9 bis 11,
**dadurch gekennzeichnet,**
**dass** das Eingangssignal (X) mit einer ersten Abtastrate, welche zumindest der doppelten in dem Eingangssignal (X) vorkommenden höchsten Frequenz entspricht, abgetastet wird,
**dass** das zumindest eine Ausgangssignal (Y(z)) mit einer zweiten Abtastrate erzeugt wird,
**dass** die zweite Abtastrate derart bestimmt wird, dass sämtliche in dem zumindest einen Teilbandsignal (36, Y₀(z), Y₁(z), ..., Y_{N-2}(z), Y_{N-1}(z)), aus welchem das Ausgangssignal (Y(z)) erzeugt wird, enthaltenen Informationen in dem Ausgangssignal (Y(z)) enthalten sind, und
**dass** die zweite Abtastrate geringer oder gleich der ersten Abtastrate bestimmt wird.

13. Verfahren nach einem der Ansprüche 9 bis 12,
**dadurch gekennzeichnet,**
**dass** zumindest ein Teilbandsignal (35, X₀(z), X₁(z) ,..., X_{M-2}(z), X_{M-1}(z)) gespeichert wird.

## Claims

1. Signal processing device with a signal analysis unit (30), a signal synthesis unit (32) and a detection unit (34),
wherein the signal analysis unit (30) receives an input signal (X) and generates a plurality of part band signals (35, X₀(z), X₁(z), ..., X_{M-2}(z), X_{M-1}(z)) therefrom,
wherein the signal synthesis unit (32) generates at least one output signal (Y(z)) from at least one part band signal (36, Y₀(z), Y₁(z), ..., Y_{N-2}(z), Y_{N-1}(z)),
wherein the detection unit (34) automatically determines from which part band signals (36, Y₀(z), Y₁(z),..., Y_{N-2}(z), Y_{N-1}(z)) the signal synthesis unit (32) generates the output signal (Y(z)),
wherein the detection unit (34) determines the power of the part band signals (35, (X₀(z), X₁(z),..., X_{M-2}(z), X_{M-1}(z)),
wherein the detection unit (34) automatically determines, by reference to the powers of the part band signals (35, (X₀(z), X₁(z), ..., X_{M-2}(z), X_{M-1}(z)), from which part band signals (36, (Y₀(z), Y₁(z), ..., Y_{N-2}(z), Y_{N-1}(z)) the signal synthesis unit (32) generates the output signal (Y(z)),
wherein the input signal (X) comprises a plurality of part signals (10, 11, 81, 82, 83, 84, 85, 86), and wherein the signal synthesis unit (32) of the signal processing device processes the plurality of part signals (10, 11, 81, 82, 83, 84, 85, 86) sequentially so that the processing time (T₂, T₃, T₄, T₅, T₆, T₇) required by the signal processing device for processing of a part signal (10, 11, 81, 82, 83, 84, 85, 86) is directly proportional to the band width of the respective part signal (10, 11, 81, 82, 83, 84, 85, 86).

2. Signal processing device according to claim 1, **characterised in that**
the signal synthesis unit (32) generates at least one output signal (Y(z)) from a plurality of part band signals (36, Y₀(z), Y₁(z), ..., Y_{N-2}(z), Y_{N-1}(z)), and
**in that** the signal synthesis unit (32) processes the plurality of part band signals (36, Y₀(z), Y₁(z), ..., Y_{N-2}(z), Y_{N-1}(z)) in parallel.

3. Signal processing device according to claim 1 or 2, **characterised in that**
the signal synthesis unit (32) generates a common output signal (Y(z)) from a plurality of part band signals (36, Y₀(z), Y₁(z), ..., Y_{N-2}(z), Y_{N-1}(z)) adjacent to one another on the frequency axis.

4. Signal processing device according to one of claims 1 to 3,
**characterised in that**
the signal analysis unit (30) samples the input signal (X) with a first sampling rate which is at least double the highest frequency occurring in the input signal (X), **in that** the signal synthesis unit (32) generates the at least one output signal (Y(z)) with a second sampling rate,
**in that** the signal synthesis unit (32) determines the second sampling rate such that all the information contained in the at least one part band signal (36, Y₀(z), Y₁(z), ..., Y_{N-2}(z), Y_{N-1}(z)) from which it generates the output signal (Y(z)) is contained in the output signal (Y(z)), and
**in that** the second sampling rate is less than or equal to the first sampling rate.

5. Signal processing device according to one of claims 1 to 4,
**characterised in that**
the signal processing device comprises a processing unit (33), and
**in that** the processing unit (33) analyses the at least one output signal (Y(z)).

6. Signal processing device according to one of claims 1 to 5,
**characterised in that**
the signal processing device comprises a storage unit (31), and
**in that** at least one part band signal (35, X₀(z), X₁(z), ..., X_{M-2}(z), X_{M-1}(z)) is stored by the storage unit.

7. Signal processing device according to one of claims 1 to 6,
**characterised in that**
the signal analysis unit (30) comprises a first polyphase filter bank, and
**in that** the signal synthesis unit (32) comprises a second polyphase filter bank.

8. Signal processing device according to one of claims 1 to 7,
**characterised in that**
at least the signal analysis unit (30), the detection unit (34) and/or the signal synthesis unit (32) are realized by at least one field-programmable gate array (FPGA) or an application-specific integrated circuit (ASIC).

9. Method for signal processing with the following steps:
- reception of an input signal (X),
- generation of a plurality of part band signals (35, X₀(z), X₁(z), ..., X_{M-2}(z), X_{M-1}(z)) from the input signal (X),
- generation of at least one output signal (Y(z)) from the part band signals (36, Y₀(z), Y₁(z), ..., Y_{N-2}(z), Y_{N-1}(z)),
wherein it is automatically determined from which part band signals (36, Y₀(z), Y₁(z), ..., Y_{N-2}(z), Y_{N-1}(z)) the output signal (Y(z)) is generated,
wherein the power of a plurality of part band signals (35, X₀(z), X₁(z), ..., X_{M-2}(z), X_{M-1}(z)) of the input signal (X) is determined,
wherein it is automatically determined, by reference to the powers of the part band signals (35, X₀(z),
X₁(z), ..., X_{M-2}(z), X_{M-1}(z)), from which part band signals (36, Y₀(z), Y₁(z), ..., Y_{N-2}(z), Y_{N-1}(z)) the output signal (Y(z)) is generated,
wherein the input signal (X) comprises a plurality of part signals (10, 11, 81, 82, 83, 84, 85, 86), and wherein the plurality of part signals (10, 11, 81, 82, 83, 84, 85, 86) are processed sequentially so that the processing time (T₂, T₃, T₄, T₅, T₆, T₇) required for processing of a part signal (10, 11, 81, 82, 83, 84, 85, 86) is directly proportional to the band width of the respective part signal (10, 11, 81, 82, 83, 84, 85, 86).

10. Method according to claim 9,
**characterised in that**
at least one output signal (Y(z) is generated from a plurality of part band signals (36, Y₀(z), Y₁(z), ..., Y_{N-2}(z), Y_{N-1}(z)), and
**in that** the plurality of part band signals (36, Y₀(z), Y₁(z), ..., Y_{N-2}(z), Y_{N-1}(z)) are processed in parallel.

11. Method according to claim 9 or 10,
**characterised in that**
a common output signal (Y(z)) is generated from a plurality of part band signals (36, Y₀(z), Y₁(z), ..., Y_{N-2}(z), Y_{N-1}(z)) adjacent to one another on the frequency axis.

12. Method according to one of claims 9 to 11,
**characterised in that**
the input signal (X) is sampled with a first sampling rate which is at least double the highest frequency occurring in the input signal (X),
**in that** the at least one output signal (Y(z)) is generated with a second sampling rate,
**in that** the second sampling rate is determined such that all the information contained in the at least one part band signal (36, Y₀(z), Y₁(z), ..., Y_{N-2}(z), Y_{N-1}(z)) from which the output signal (Y(z)) is generated, is contained in the output signal (Y(z)), and
**in that** the second sampling rate is determined so that it is less than or equal to the first sampling rate.

13. Method according to one of claims 9 to 12,
**characterised in that**
at least one part band signal (35, X₀(z), X₁(z), ..., X_{M-2} (z), X_{M-1}(z)) is stored.

## Revendications

1. Dispositif de traitement de signal comprenant un dispositif d'analyse de signal (30), un dispositif de synthèse de signal (32) et un dispositif de détection (34),
dans lequel le dispositif d'analyse de signal (30) reçoit un signal d'entrée (X) et génère à partir de celui-ci plusieurs parties de signal de bande (35, X₀(z), X₁(z), ..., X_{M-2}(z), X_{M-1}(z)),
dans lequel le dispositif de synthèse de signal (32) génère à partir d'au moins une partie de signal de bande (36, Y₀(z), Y₁(z),..., Y_{N-2}(z), Yₙ₋₁(z)) au moins un signal de sortie (Y(z)),
dans lequel le dispositif de détection (34) détermine automatiquement à partir desquelles parties de signal de bande (36, Y₀(z), Y₁(z), ..., Y_{N-2}(z), Y_{N-1}(z)) le dispositif de synthèse de signal (32) génère le signal de sortie (Y(z)),
dans lequel le dispositif de détection (34) détermine la puissance des parties de signal de bande (35, X₀(z), X₁(z), ..., X_{M-2} (Z), X_{M-1}(z)),
dans lequel le dispositif de détection (34) détermine automatiquement sur la base des puissances des parties de signal de bande (35, X₀(z), X₁(z), ..., X_{M-2}(z), X_{M-1}(z)) à partir desquelles parties de signal de bande (36, Y₀(z), Y₁(z), ..., Y_{N-2}(z), Y_{N-1}(z)) le dispositif de synthèse de signal (32) génère le signal de sortie (Y(z)),
dans lequel le signal d'entrée (X) comporte plusieurs parties de signal (10, 11, 81, 82, 83, 84, 85, 86), et
dans lequel le dispositif de synthèse de signal (32) du dispositif de traitement de signal traite les différentes parties de signal (10, 11, 81, 82, 83, 84, 85, 86) de manière séquentielle, de sorte que le temps de traitement (T₂, T₃, T₄, T₅, T₆, T₇) nécessaire au traitement d'une partie de signal (10, 11, 81, 82, 83, 84, 85, 86) par le dispositif de traitement de signal est directement proportionnel à la bande passante de la partie de signal (10, 11, 81, 82, 83, 84, 85, 86) respective.

2. Dispositif de traitement de signal selon la revendication 1,
**caractérisé**
**en ce que** le dispositif de synthèse de signal (32) génère au moins un signal de sortie (Y(z)) à partir de plusieurs parties de signal de bande (36, Y₀(z), Y₁(z), ..., Y_{N-2}(z), Y_{N-1}(z)), et
**en ce que** le dispositif de synthèse de signal (32) traite en parallèle les différentes parties de signal de bande (36, Y₀(z), Y₁(z), ..., Y_{N-2}(z), Y_{N-1}(z)).

3. Dispositif de traitement de signal selon la revendication 1 ou 2,
**caractérisé**
**en ce que** le dispositif de synthèse de signal (32) génère un signal de sortie (Y(z)) commun à partir de plusieurs parties de signal de bande (36, Y₀(z), Y₁(z), ..., Y_{N-2}(z), Y_{N-1}(z)) voisines sur l'axe de fréquence.

4. Dispositif de traitement de signal selon l'une quelconque des revendications 1 à 3,
**caractérisé**
**en ce que** le dispositif d'analyse de signal (30) échantillonne le signal d'entrée (X) à une première fréquence d'échantillonnage qui correspond au moins à la double fréquence la plus élevée trouvée dans le signal d'entrée (X),
**en ce que** le dispositif de synthèse de signal (32) génère le au moins un signal de sortie (Y(z)) à une deuxième fréquence d'échantillonnage,
**en ce que** le dispositif de synthèse de signal (32) détermine la deuxième fréquence d'échantillonnage de telle manière que toutes les informations contenues dans la au moins une partie de signal de bande (36, Y₀(z), Y₁(z), ..., Y_{N-2}(z), Y_{N-1}(z)) à partir desquelles il génère le signal de sortie (Y(z)) sont contenues dans le signal de sortie (Y(z)), et
**en ce que** la deuxième fréquence d'échantillonnage est inférieure ou égale à la première fréquence d'échantillonnage.

5. Dispositif de traitement de signal selon l'une quelconque des revendications 1 à 4,
**caractérisé**
**en ce que** le dispositif de traitement de signal comporte un dispositif de traitement (33), et
**en ce que** le dispositif de traitement (33) analyse le au moins un signal de sortie (Y(z)).

6. Dispositif de traitement de signal selon l'une quelconque des revendications 1 à 5,
**caractérisé**
**en ce que** le dispositif de traitement de signal comporte un dispositif de mise en mémoire (31), et
**en ce qu'**au moins une partie de signal de bande (35, X₀(z), X₁(z), ..., X_{M-2}(z), X_{M-1}(z)) est mise en mémoire par le dispositif de mise en mémoire.

7. Dispositif de traitement de signal selon l'une quelconque des revendications 1 à 6,
**caractérisé**
**en ce que** le dispositif d'analyse de signal (30) comporte un premier banc de filtres polyphasés, et
**en ce que** le dispositif d'analyse de signal (32) comporte un deuxième banc de filtres polyphasés.

8. Dispositif de traitement de signal selon l'une quelconque des revendications 1 à 7,
**caractérisé**
**en ce qu'**au moins le dispositif d'analyse de signal (30), le dispositif de détection (34) et/ou le dispositif de synthèse de signal (32) sont réalisés par au moins un réseau de portes programmables in situ (FPGA) ou un circuit intégré à application spécifique (ASIC).

9. Procédé de traitement de signal comprenant les étapes suivantes :
- la réception d'un signal d'entrée (X),
- la génération de plusieurs parties de signal de bande (35, X₀(z), X₁(z) ..., X_{M-2}(z), X_{M-1}(z)) à partir du signal d'entrée (X),
- la génération d'au moins un signal de sortie (Y(z)) à partir des parties de signal de bande (36, Y₀(z), Y₁(z), ..., Y_{N-2}(z), Y_{N-1}(z)),
en ce qu'il est déterminé automatiquement à partir desquelles parties de signal de bande (36, Y₀(z), Y₁(z), ..., Y_{N-2}(z), Y_{N-1}(z)) le signal de sortie (Y(z)) est généré,
dans lequel la puissance de plusieurs parties de signal de bande (35, X₀(z), X₁(z),..., X_{M-2}(z), X_{M-1}(z)) du signal d'entrée (X) est déterminée,
dans lequel il est déterminé automatiquement sur la base des puissances des parties de signal de bande (35, X₀(z), X₁(z), ..., X_{M-2} (Z), X_{M-1}(z)) à partir desquelles parties de signal de bande (36, Y₀(z), Y₁(z), ..., Y_{N-2}(z), Y_{N-1}(z)) le signal de sortie (Y(z)) est généré,
dans lequel le signal d'entrée (X) comporte plusieurs parties de signal (10, 11, 81, 82, 83, 84, 85, 86), et
dans lequel les différentes parties de signal (10, 11, 81, 82, 83, 84, 85, 86) sont traitées de manière séquentielle, de sorte que le temps de traitement (T₂, T₃, T₄, T₅, T₆, T₇) nécessaire au traitement d'une partie de signal (10, 11, 81, 82, 83, 84, 85, 86) est directement proportionnel à la bande passante de la partie de signal (10, 11, 81, 82, 83, 84, 85, 86) respective.

10. Procédé selon la revendication 9,
**caractérisé**
**en ce qu'**au moins un signal de sortie (Y(z)) est généré à partir de plusieurs parties de signal de bande (36, Y₀(z), Y₁(z), ..., Y_{N-2}(Z), Y_{N-1}(z)), et
**en ce que** les différentes parties de signal de bande (36, Y₀(z), Y₁(z), ..., Y_{N-2}(z), Y_{N-1}(z)) sont traitées en parallèle.

11. Procédé selon la revendication 9 ou 10,
**caractérisé**
**en ce qu'**un signal de sortie (Y(z)) commun est généré à partir de plusieurs parties de signal de bande (36, Y₀(z), Y₁(z), Y_{N-2}(z), Y_{N-1}(z)) voisines de l'axe de fréquence.

12. Procédé selon l'une quelconque des revendications 9 à 11,
**caractérisé**
**en ce que** le signal d'entrée (X) est échantillonné à une première fréquence d'échantillonnage qui correspond au moins à la double fréquence la plus élevée trouvée dans le signal d'entrée (X),
**en ce que** le au moins un signal de sortie (Y(z)) est généré à une deuxième fréquence d'échantillonnage,
**en ce que** la deuxième fréquence d'échantillonnage est déterminée de telle manière que toutes les informations contenues dans la au moins une partie de signal de bande (36, Y₀(z), Y₁(z), Y_{N-2}(z), Y_{N-1}(z)) à partir desquelles le signal de sortie (Y(z)) est généré sont contenues dans le signal de sortie (Y(z)), et
**en ce que** la deuxième fréquence d'échantillonnage est inférieure ou égale à la première fréquence d'échantillonnage.

13. Procédé selon l'une quelconque des revendications 9 à 12,
**caractérisé**
**en ce qu'**au moins une partie de signal de bande (35, X₀(z), X₁(z), ..., X_{M-2}(z), X_{M-1}(z)) est mise en mémoire.
